(19) Europäisches Patentamt
European Patent Office
Office européen des brevets

(11) Publication number: **0 030 347**
**B1**

(12) **EUROPEAN PATENT SPECIFICATION**

(45) Date of publication of patent specification: **01.04.87**

(51) Int. Cl.[4]: **H 01 J 37/304,** H 01 J 37/153

(21) Application number: **80107513.6**

(22) Date of filing: **02.12.80**

(54) **Electron beam exposure system and apparatus for carrying out the same.**

(30) Priority: **10.12.79 JP 159920/79**

(43) Date of publication of application:
**17.06.81 Bulletin 81/24**

(45) Publication of the grant of the patent:
**01.04.87 Bulletin 87/14**

(84) Designated Contracting States:
**DE FR GB NL**

(56) References cited:
**FR-A-2 276 624**
**FR-A-2 337 420**

**PROCEEDINGS OF THE SYMPOSIUM ON ELECTRON AND ION BEAM SCIENCE AND TECHNOLOGY, Eighth International Conference, vol. 78, no. 5, 1979 Princeton, US R. VISWANATHAN et al.: "Distortion Correction in Scanning Electron Beam Systems", pages 44-56**

(73) Proprietor: **FUJITSU LIMITED**
**1015, Kamikodanaka Nakahara-ku**
**Kawasaki-shi Kanagawa 211 (JP)**

(72) Inventor: **Yasuda, Hiroshi**
**916-1, Mamedo-cho Kohoku-ku**
**Yokohama-shi Kanagawa 222 (JP)**

(74) Representative: **Seeger, Wolfgang, Dipl.-Phys.**
**European Patent Attorney Bereiteranger 15**
**D-8000 München 90 (DE)**

(56) References cited:
**RADIO EINGINEERING AND ELECTRONIC PHYSICS, vol. 14, no. 11, november 1969, G.V. DER-SHVARTS et al.: "An electron-Optical Narrow Beam System with Magnetic Deflection, Astigmatism Correction and Curvature Defocusing of the Deflected Beam", pages 1804-1807**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 030 347 B1**

## Description

The present invention relates to a process for exposing a substrate (10) to an electron beam so as to produce a predetermined pattern in which the substrate is placed on a continuously moving stage (11) and to an electron beam exposure apparatus comprising an exposing means including a continuously movable stage (11), a mechanism for projecting a rectangular electron beam (B) in variable cross-section onto the substrate (10) placed on the stage (11), and a deflection coil (8) for the electron beam (B).

The electron beam exposure system is well known as a method for forming minute patterns of an LSI (Large Scale Integrated Circuit). This electron beam exposure system is classified into the step and repeat system where patterns are depicted on the wafer by repeating a process to which a wafer is exposed, for example the exposure to a beam having a variable rectangular cross-section, then shifted by one step and then exposed to said beam, whereby the stage bearing said wafers is shifted step by step, and the continuous stage moving system where patterns are depicted by projecting the beam onto the wafers while said stage is being moved continuously.

In the former system, the electron beam deflection range is comparatively as wide as 2 (two) to 5 (five) mm square, and the stage is moved 2 to 5 mm in a direction and stopped, to project the electron beam on a wafer, and then is moved 2 to 5 mm after the projection. The exposed portions are thus sequentially formed by repeating such operations. In the latter system, the stage moves continuously at a rate of about 20 mm/sec, the beam is scanned in the range as narrow as about 250 μm at a right angle to the moving direction of the wafer, and thereby patterns are depicted on the wafers.

The former step and repeat system has the merit that the beam position control is easy at the time of depicting patterns since the stage is in the stationary condition, but also has the demerit that compensation for aberrations such as distortion, field curvature, astigmatism etc. is required since the deflection width of electron beam is wide and the movement of stage lacks smoothness because it is moved step by step for every pattern depiction and permanently subjected to acceleration and deceleration. On the other hand, the continuous stage moving system has the merit that the stage moves smoothly and naturally on account of the continuous movement of the stage and variety of compensations mentioned above are not required due to narrow deflection of the electron beam however it also has the demerit that the beam position control is complicated owing to the continuous movement of the stage, and that the limited deflection of the electron beam lowers the output of the exposing process, thereby requiring a longer period for depicting desired patterns.

FR—A—2 276 624 discloses an electron beam exposing process and apparatus which employ the step and repeat system. In this process a workpiece is placed at a predetermined position and the beam deflection data itself, corrected by the correction amount which is derived from the equation shown in this reference, is applied to the deflection means.

It is an object of the present invention to provide a highly accurate and high speed electron beam exposing process having the merits of both step and repeat system and the continuous stage shifting system outlined above.

This object has been solved by the features of claim 1.

It is another object of the present invention to provide an apparatus for accurate high speed electron beam exposure.

This object has been solved by the features of claim 2.

Further features and advantages of the present invention will be apparent from the following description with reference to the accompanying drawings, to which, however, the scope of the invention is in no way limited:

Figure 1 shows as a whole the structure of an embodiment of the present invention;
Figures 2A, 2B, 2C respectively show the focus coils and stigmator coils;
Figure 3 explains the variable rectangular beam system;
Figure 4 shows chips of a wafer;
Figure 5 explains a method of exposing the patterns in combination with the rectangular beam;
Figures 6A, 6B, 6C, 6D explain the field curvature, astigmatism and distortion;
Figure 7 explains the contents of a correction memory;
Figure 8 shows layout of the wafer, stage and laser interferometers;
Figure 9 shows the exposed field and exposed pattern in a chip;
Figure 10 explains contents of a pattern memory;
Figure 11A, 11B, 11C explain contents of a register.

Figure 1 and Figure 2 respectively show the embodiment of the electron beam exposure apparatus of the present invention. In these figures, G is an electron gun and B is the electron beam emitted from said electron gun, 1 is a first slit for the electron beam B. 2 designates deflection plates for shaping the electron beam section into a variable rectangular shape by means of a second slit 3, 4 designates electron lenses for focusing and image forming and 5, deflection plates for correcting distortion, 6 is a stigmator coil, 7 is a focus coil, 8 is a deflection coil, 9 is a convergence coil and 10 is a medium such as a wafer placed on a stage 11 which moves continuously. The electron beam B emitted from the electron gun G is converged by the second electron lens 4 whereby an image of the first slit 1 is formed in the plane of the second slit 3 and deflected by the deflection plate 2. Thus, for example, the portion Ba indicated by the mesh of Fig. 3 of the

electron beam B passes the aperture 3a of the second slit 3 and is shaped into a rectangular beam, and projected to the desired position on the wafer 10 via the electron lens, convergence coil and deflection coil etc. The semiconductor wafer 10 allows, as indicated in Fig. 4, formation of many integrated circuit chips 10a, 10b,... (these are scribed into individual IC chips) and usually respective chips have the same patterns, namely the same internal element arrangement. The electron beam B is projected on these chips and each pattern of the integrated circuit chip is depicted by the procedures indicated in Fig. 5, namely a desired pattern is depicted in unit of individual rectangular patterns B1, B2, B3,... and by adequately combining them, namely the exposing of the photoresist is performed. The exposed location on the wafer is shifted in the present invention by the movement of stage 11 and beam deflection by the deflection coil 8. A computer 12 is used for such control. 13 is a memory for storing pattern data of said integrated circuit chips. 14 is a register which stores data of the field coordinates of the chips on the wafer; 15 is an adder for adding a readout signal $S_1$ from the memory 13 and the signal $S_2$ which means the field coordinates from 14 and thereby outputs a combined signal $S_3$; 16 is a dynamic correction memory which stores correction data for correcting the field curvature, the astigmatism and the distortion of the electron beam. The field coordinates are represented by the specific points of chips on the wafer, for example, by the coordinates of the points P1, P2,... and the signal $S_3$ obtained by adding such field coordinate signal and the output signal $S_1$ of the memory 13 indicates the coordinates of individual IC patterns on the wafer.

The stage 11 is driven in the X and Y directions by a motor, not illustrated, and the locations, more specifically, the field coordinates X, Y of the wafer on said stage, are measured by the laser interferometer 17. The wafer 10 is not always placed on the stage 11 in the desired position and usually it is deviated from that position or rotated by a certain angle with respect to the X and Y directions 18 is a primary converter consisting of the matrix circuit which performs addition/subtraction and multiplication/division in order to correct such positional deviation. For example, deviation from the desired position is determined by measuring the positions of three marks determining the plane of the wafer and detected by the electron beams, the output of the laser interferometer 17 is corrected in accordance with said deviation and said output is set to the coordinates predetermined by the memory 13 and the register 14. 19 is a subtractor which outputs a difference signal $S_6$ obtained by subtracting the signal $S_5$ of the converter 18 from the signal $S_3$ of said adder 15. The output signal $S_6$ of the subtractor 19 is supplied to the amplifier 24 via the primary converter 18. The amplifier 24 converts the digital signal $S_6$ to the analog signal $S_{10}$ and amplifies said signal in order to excite the deflection coil 8.

Here, said field curvature, astigmatism, distortion will be explained by referring to Fig. 6.

Investigated is the shift of the pattern $P_0$ from the position $(x_0, y_0)$ to the positions $(x_1, y_1)$ $(x_2, y_2)$, $(x_3, y_3)$ $(x_4, y_4)$ as indicated in Fig. 6A.

When the pattern $P_0$ is at the position $(x_0, y_0)$, a correct pattern is depicted through correct focusing of the electron lens system, but when the electron beam is deviated, the focusing is impaired and the pattern is blurred as indicated in Fig. 6B. This is called the field curvature.

However, the pattern is actually not only blurred but also deformed as the electron beam is deflected, as indicated in Fig. 6C. This is called the astigmatism.

Therefore, the correct pattern indicated in Fig. 6A can be depicted by correcting astigmatism to change the pattern of Fig. 6C into the pattern of Fig. 6B and by correcting the field curvature.

After the above mentioned correction of the field curvature and astigmatism, in regard to the patterns $P_1$, $P_2$, $P_3$ and $P_4$ arranged at four corners for the pattern $P_0$ at the position $(x_0, y_0)$ as indicated in Fig. 6D, the deflection information sent from the CPU and the actual deflection of the electron beam are adjusted, and the electron beam is deflected to the desired position.

In this case, the pattern is depicted at the correct position like the patterns $P_1$, $P_2$, $P_3$, $P_4$ on the diagonal of the square with the center $P_0$. However, if it is attempted, for example, to depict the pattern $P_0'$ of the position $(x_m, y_0)$, i.e. if the order to shift the pattern $P_0$ to the position $(x_m, y_0)$ is given to the electron optical column by the CPU, the electron beam is actually deflected to the position $(x_n, y_0)$ and the pattern $P_0''$ is depicted. Such deviation of the deflection position is called the distortion.

The focus coil 7 used for correcting the above mentioned field curvature is a ring shaped coil, wound in such a way that it surrounds the electron beam B, as indicated in Fig. 2A.

The stigmator coil 6 used for correcting astigmatism consists of eight solenoid coils $a_1,\ldots a_4$ and $b_1,\ldots,b_4$ which are arranged in the same plane with an interval of 45 degrees.

Figures 2B, 2C show the coils in the form of block and also indicate mutual connections.

The coils $a_1,\ldots,a_4$ have the same number of turns and are connected in series in the way which is apparent from Fig. 2B that the winding appears in every another coil. Therefore, when a current is supplied to each coil, the pole N appears on the side of the space by the coils in the case of coils $a_1$ and $a_3$, and the pole S in the case of the coil $a_2$ and $a_4$. Thereby, as indicated in the figure, the magnetic lines of force $m_1$, $m_2$, $m_3$, $m_4$ appear.

Thus, for example, the circular beam Ci can be deformed vertically or horizontally as indicated by the dotted line by controlling a current flowing through the coils.

Also, it suggests that the ellipse beam indicated by the dotted line can be shaped to the circular beam $C_i$.

On the other hand, the coils $b_1,\ldots,b_4$ indicated in Fig. 2C have the same structure as the coils $a_1,\ldots,a_4$ indicated in Fig. 2B and they are arranged with displacement of only 45 degrees.

Therefore, the electron beam can be shaped in such a way that it is only rotated by 45 degrees with respect to that of Fig. 2B. As will be obvious from above explanation, the electron beam can be shaped freely by combining the coils of Fig. 2B, 2C as indicated in Fig. 2A. The distortion changes depending on the deflection angle, but is also influenced by the correction of field curvature and astigmatism. Therefore, distortion can be considered as a function of the beam deflection angle θ, the field curvature and the astigmatism. At any rate, since these values are determined when a deflection angle θ is determined, correction data of said values for respective deflection angles are written into the memory 16, 21 to 23 are amplifiers for activating the deflection plates 5, stigmator coil 6, focus coil 7 through DA conversion of the output of said memory.

Figure 7 shows the contents of the memory 16. A region to be exposed to the electron beam is divided into j sections in the direction X and i sections in the direction Y (i, j are integers).

Thereby, the region to be exposed can be considered as the collection of the minute sub-regions having the addresses from ($ax_1$, $ay_2$) to (axj, ayi).

Here, the correction amount of the field curvature at the address ($ax_1$, $ay_1$) is pre-obtained as $f_1$, the correction amount of the astigmatism in the direction X as $Sx_1$ and that in the direction Y as $Sy_1$, the correction amount of distortion in the direction X as $dy_1$ and the correction amount corresponding to each address up to (axj, ayi) is obtained previous to the exposure in the same way, and moreover each correction amount is stored in the memory 16. This address corresponds to the deflection amount of the electron beam as will be explained later.

Figure 8 shows the plan view of the wafer 10 placed on the stage 11.

Mirrors 81, 82 are respectively provided on the sides of the stage 11 in the directions of X and Y, and laser interferometers 17X and 17Y are provided for detecting the position of the stage 11 in the directions X and Y, respectively.

The stage 11 is continuously moved in the directions X and Y by a motor not illustrated, and thereby the wafer 10 is sequentially and continuously exposed as indicated by the arrow 83. Figure 9 shows an enlarged portion of the wafer 10. The chips, of which the size is lx×ly, are arranged in the form of a matrix on the wafer 10 and each chip consists of three exposing fields $F_1$, $F_2$ and $F_3$, the size of each one being $l_x \times l_f$.

In general $l_x > l_f$ in the extent of the exposed field and $l_f$ is as small as 1/5 to 1/2 of the deflection width of the electron beam. The size $l_x$ of a little smaller than the deflection width of the electron beam.

In the field $F_1$, the patterns $Q_1$, $Q_2$, $Q_3$, $Q_4$ are to be exposed, while $Q_5$ and $Q_6$ in the field $F_2$, and $Q_7$ and $Q_8$ in the field $F_3$ are to be exposed. The origins of the fields $F_1$, $F_2$ and $F_3$ are respectively indicated by $O_1$, $O_2$ and $O_3$.

The contents indicated in Fig. 10 is transferred to the pattern memory 13 from the CPU 12 and stored therein.

When it is supposed that the positional coordinates indicated in Figure 9 by the dot of the pattern $Q_1$ in the field $F_1$ are ($x_1$, $y_1$), the length in the direction X of the pattern dimension is $l_1$ and the length in the direction Y is $l_1'$, and in the same way, the positional coordinates and pattern dimensions are set to the patterns up to pattern $Q_8$ and these data are stored in the pattern memory 13 of Figure 10.

On the other hand, the coordinates of the origin of each field $F_1$, $F_2$, $F_3$ are transferred from the CPU 12 to the register 14 and stored therein.

Namely, when the pattern in the field $F_1$ is to be exposed, the coordinate ($O_{1x}$, $O_{1y}$) of the origin $O_1$ of the field $F_1$ indicated in Figure 9 are stored in the register 14 as indicated in Figure 11A.

In the same way, the coordinates of origins ($O_{2x}$, $O_{2y}$), ($O_{3x}$, $O_{3y}$) as indicated in Figure 11B for the field $F_2$ or as indicated in Figure 11C for the field $F_3$ are stored in the register.

For this reason, in case the pattern $Q_1$ in the field $F_1$ is to be exposed, the data $x_1$, $y_1$, $l_1$ and $l_1'$ are read out from the pattern memory 13, while the data $O_{1x}$, $O_{1y}$ are obtained from the register 14. Then, these are added in the adder 15. Thereby, the deflection amount from the origin of exposure can be obtained, if the stage is not moved.

Namely, the output signal $S_3$ in Fig. 1 indicates the coordinates of pattern in the relevant chip (the chip of the wafer 10 specified by the field coordinate register 14). On the other hand, the laser interferometer 17 provides the current position signal $S_4$ of the wafer 10. This signal is subtracted from the signal $S_3$ by the subtractor 19, the difference output signal of the subtractor 19 is corrected by the primary converter 18, and the output $S_6$ indicates the amount of deflection of electron beam. The deflection coil 8 is activated in accordance with such signal $S_6$ and therefore the beam is projected to the desired position in accordance with the data of pattern coordinates. The stage moves but, since the beam projection period is very short, the wafer is considered to be stationary during projection of electron beam. The difference signal $S_6$ is also used for retrieval of memory 16, and the correction amount f, $S_x$, $S_y$, $d_x$, $d_y$ of the field curvature, astigmatism and distortion corresponding to the deflection amount of the electron beam are read out and then supplied to the respective adjusting means 5, 6, 7 via the amplifiers 21 to 23.

In case the pattern $Q_1$ is to be exposed, the deflection amounts $\overline{X}$, $\overline{Y}$ are obtained through the following equation:

$$\begin{pmatrix} \overline{X} \\ \overline{Y} \end{pmatrix} = \begin{pmatrix} a_{11} & a_{12} \\ a_{21} & a_{22} \end{pmatrix} \begin{pmatrix} x_1 + X_p - X(t) \\ y_1 + Y_p - Y(t) \end{pmatrix} + \begin{pmatrix} a_{13} \\ a_{23} \end{pmatrix}$$

Here, $a_{11}$, $a_{22}$ are gains, $a_{12}$, $a_{21}$ are rotation of wafer; $a_{13}$, $a_{23}$ are offset, $(x_1, y_1)$ are the coordinates of the origin $O_1$ of the pattern $Q_1$, while $(X_p, Y_p)$ are the coordinates of the origin $O_1$ and (X(t), Y(t)) are the outputs of the laser interferometers, namely the positional coordinates of the stage. Above primary conversion is carried out by the primary converter 18 of Figure 1.

The deflection amount $\bar{X}$, $\bar{Y}$, obtained thereby becomes the address $a_x$, $a_y$ in the correction memory 16 of Fig. 7 and the amount of corrections f, $S_x$, $S_y$, $d_x$, $d_y$ of the corresponding field curvature, astigmatism and distortion are read out with such address used as the index and then input to the correction means 5, 6 and 7.

As explained in detail, the electron beam exposure system and the apparatus for the same have offered a variety of effects such as a high speed formation of pattern and accurate depiction of patterns since the stage is moved continuously and the rectangular electron beam is projected with a large deflection angle.

**Claims**

1. A process for exposing a substrate (10) to an electron beam so as to produce a predetermined pattern in which the substrate is placed on a continuously moving stage (11), characterized in that electron beam correction data ($S_x$, $S_y$, $d_x$, $d_y$) relating to at least one aberration of the group comprising field curvature, astigmatism and distortion which vary as functions of the beam deflection, are stored in a correction memory (16),

wherein said deflection is determined by a CPU (12) as a function of the variation between substrate position data, taking into account offset and rotation of the substrate, and beam position data, supplied from a memory for the predetermined pattern, and said electron beam correction data corresponding to said deflection is read out from said correction memory (16) and applied to a beam control means (5, 6, 7, 8).

2. An electron beam exposure apparatus comprising an exposing means including a continuously movable stage (11), a mechanism for projecting a rectangular electron beam (B) in variable cross-section onto the substrate (10) placed on the stage (11), and a deflection coil (8) for the electron beam (B), characterized by an adjusting means (5, 6, 7, 8) for at least one aberration of the group comprising field curvature, astigmatism and distortion, a unit (15) for outputting a beam deflection position signal with respect to the stage,

a subtractor (19) for obtaining a difference between the output of said unit (15) and an output of a signal output unit, which senses the actual position of the moving stage, a primary converter correcting the output of said subtractor, taking into account offset and rotation of the substrate, an amplifier (24) which applies the corrected output ($S_6$) of said subtractor (19) and outputs a signal ($S_{10}$) for activating said deflection coil (8), and a correction memory (16) for storing correction data ($S_x$, $S_y$, $d_x$, $d_y$) for at least one aberration of the group comprising field curvature, astigmatism, and distortion, corresponding to each deflection angle of the electron beam (B), which correction data are applied to said adjusting means (5, 6, 7) in response to the corrected output ($S_6$).

**Patentansprüche**

1. Verfahren, um ein Substrat (10) einem Elektronenstrahl auszusetzen, um so ein vorbestimmtes Muster zu erzeugen, bei welchem das Substrat auf einer kontinuierlich sich bewegenden Bühne placiert ist, dadurch gekennzeichnet, daß Elektronenstrahlkorrekturdaten ($S_x$, $S_y$, $d_x$, $d_y$), die sich auf wenigstens eine Aberration der Gruppe beziehen, welche Feldkrümmung, Astigmatismus und Verzerrung umfaßt, die sich als Funktion der Strahlablenkung ändern, in einem Korrekturspeicher (16) gespeichert werden,

bei welchem die genannte Ablenkung durch eine CPU (12) als Funktion der Veränderung zwischen Substratpositionsdaten, unter Berücksichtigung der Versetzung und der Rotation des Substrats, und der Strahlpositionsdaten, welche von einem Speicher für das vorbestimmte Muster geliefert werden, bestimmt wird und die genannten Elektronenstrahlkorrekturdaten, die der genannten Ablenkung entsprechen, aus dem genannten Korrekturspeicher (16) ausgelesen und einer Strahlensteuereinrichtung (5, 6, 7, 8) zugeführt werden.

2. Elektronenstrahlvorrichtung mit einer Bestrahlungseinrichtung, die eine kontinuierlich bewegbare Bühne (11), einen Mechanismus zum Projizieren eines rechtwinkligen Elektronenstrahls (B) mit veränderlichem Querschnitt auf das auf der Bühne (11) plazierte Substrat (10) und eine Ablenkungsspule (8) für den Elektronenstrahl (B) umfaßt, gekennzeichnet durch eine Einstelleinrichtung (5, 6, 7, 8) für wenigstens eine Aberration der Gruppe, welche Feldkrümmung,

Astigmatismus und Verzerrung umfaßt, durch eine Einheit (15) zum Ausgeben eines Strahlablenkungspositionssignals bezüglich der Bühne, einen Subtraktor (19) zur Ermittlung einer Differenz zwischen dem Ausgang der genannten Einheit (15) und einem Ausgang einer Signalausgangseinheit, welche die tatsächliche Position der sich bewegenden Bühne feststellt, einen primären Konverter, der den Ausgang des genannten Subtraktors korrigiert, unter Berücksichtigung der Versetzung und der Rotation des Substrats, einen Verstärker (24), der den korrigierten Ausgang ($S_6$) des genannten Subtraktors (19) anwendet und ein Signal ($S_{10}$) zum Aktivieren der genannten Ablenkungsspule (8) ausgibt, und einen Korrekturspeicher (16) zur Speicherung von Korrekturdaten ($S_x$, $S_y$, $d_x$, $d_y$) für wenigstens eine Aberration

der Gruppe, welche Feldkrümmung, Astigmatismus und Verzerrung umfaßt, die jedem Ablenkungswinkel des Elektronenstrahls (B) entspricht, welche Korrekturdaten der genannten Einstelleinrichtung (5, 6, 7) in Abhängigkeit von dem korrigierten Ausgang ($S_6$) zugeführt werden.

**Revendications**

1. Procédé d'exposition d'un substrat (10) à un faisceau d'électrons pour produire une configuration prédéterminée, dans lequel le substrat est placé sur une platine (11) en mouvement continu, caractérisé en ce que des données de correction de faisceau d'électrons ($S_x$, $S_y$, $d_x$, $d_y$) concernant au moins une aberration du groupe comprenant la courbure de champ, l'astigmatisme et la distorsion qui varient en fonction de la déviation du faisceau sont mémorisées dans une mémoire de correction (16), dans lequel ladite déviation est déterminée par une CPU (12) en fonction de la variation entre les données de positions du substrat, tenant compte d'un décalage et d'une rotation du substrat et des données de positions de faisceau fournies par une mémoire pour la configuration prédéterminée, et lesdites données de correction de faisceau d'électrons correspondant à ladite déviation sont lues dans ladite mémoire de correction (16) et appliquées à un dispositif de commande de faisceau (5, 6, 7, 8).

2. Appareil d'exposition à un faisceau d'électrons comportant un dispositif d'exposition comprenant une platine (11) mobile continuellement, un mécanisme pour projeter un faisceau d'électrons rectangulaire (B) de section transversale variable sur le substrat (10) placé sur la platine (11) et une bobine de déviation (8) pour le faisceau d'électrons (B), caractérisé par un dispositif de réglage (5, 6, 7, 8) pour au moins une aberration du groupe comprenant la courbure de champ, l'astigmatisme et la distorsion, une unité (15) pour émettre un signal de position de déviation de faisceau par rapport à la platine, un soustracteur (19) pour obtenir la différence entre la sortie de ladite unité (15) et une sortie d'une unité de sortie de signaux qui détectant la position réelle de la platine mobile, un convertisseur primaire qui corrige la sortie dudit soustracteur en tenant compte d'un décalage et d'une rotation du substrat, un amplificateur (24) qui applique la sortie corrigée ($S_6$) dudit soustracteur (19) et qui émet un signal ($S_{10}$) pour exciter ladite bobine de déviation (8) et une mémoire de correction (16) pour mémoriser des données de correction ($S_x$, $S_y$, $d_x$, $d_y$) pour au moins une aberration du groups comprenant la courbure de champ, l'astigmatisme et la distorsion correspondant à chaque angle de déviation du faisceau d'électrons (B), ces données de correction étant appliquées audit dispositif de réglage (5, 6, 7) en réponse à la sortie corrigée ($S_6$).

Fig. 1

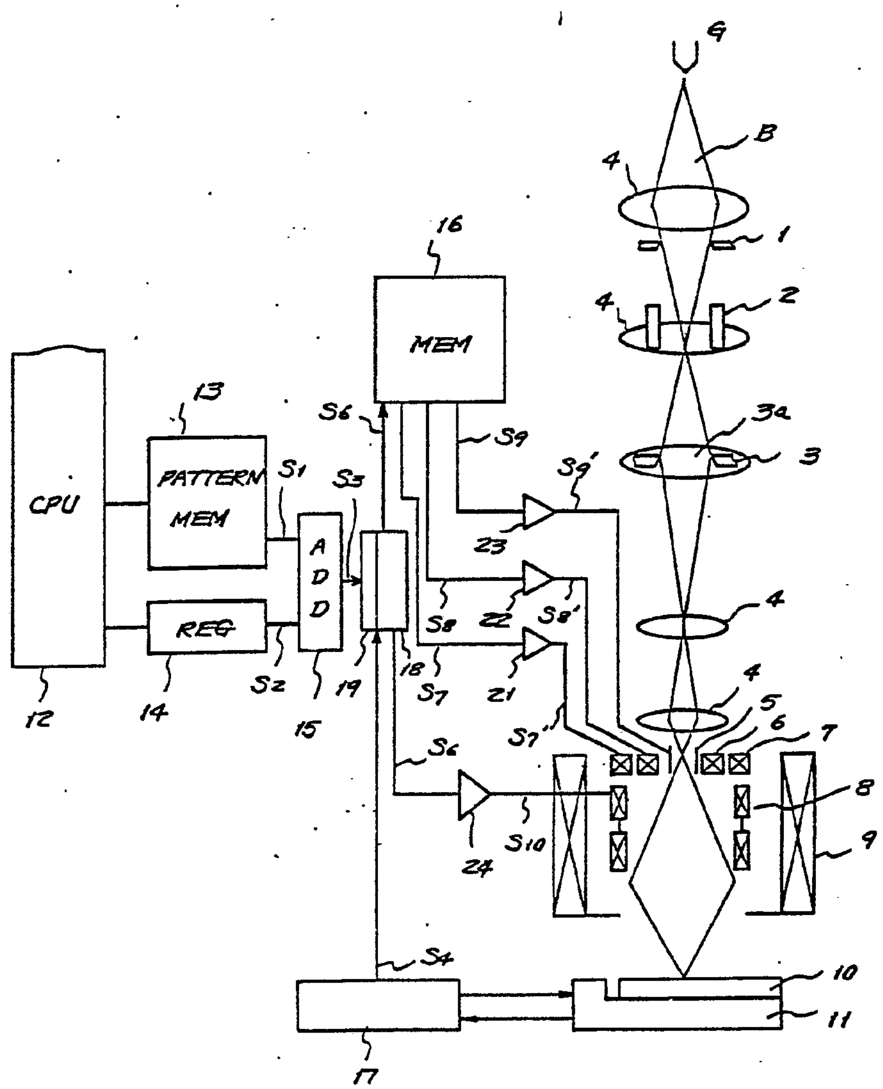
CPU
PATTERN MEM
REG
A D D
MEM
12
13
14
15
16
17
18
19
S1
S2
S3
S4
S6
S7
S8
S9
S7'
S8'
S9'
S10
21
22
23
24
G
B
1
2
3
3a
4
5
6
7
8
9
10
11

Fig. 2A

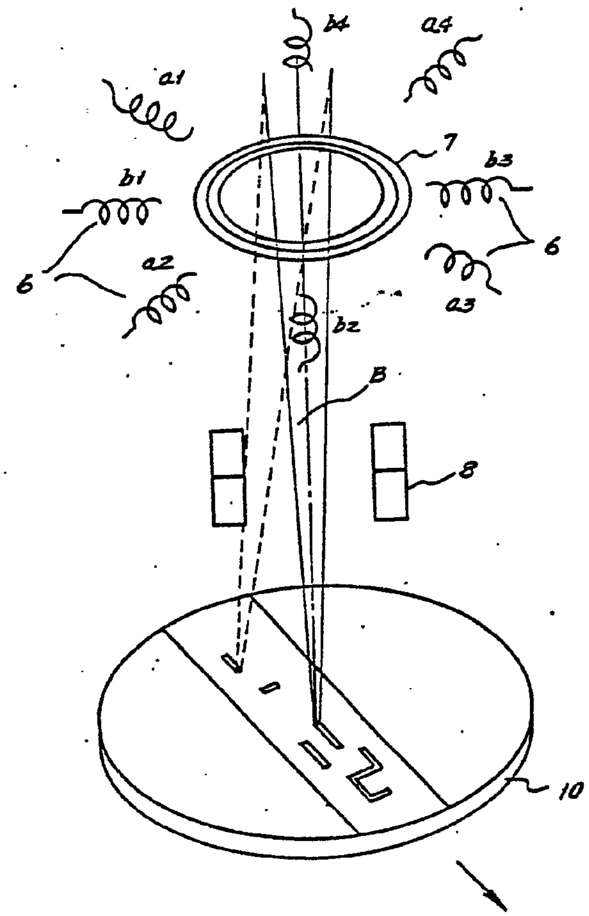

Fig. 2B

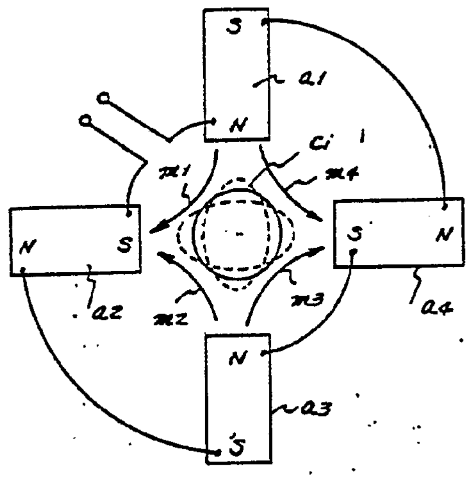


Fig. 2C

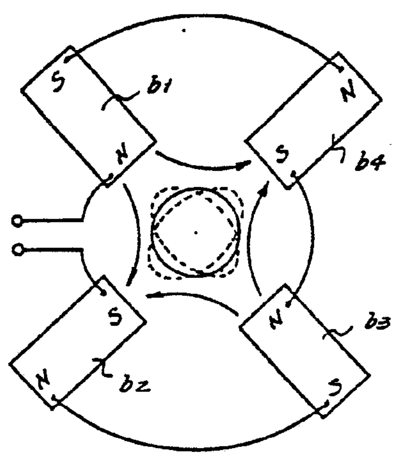

Fig. 3

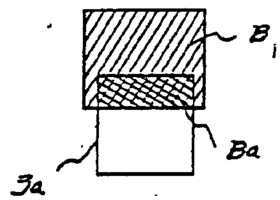


Fig. 4

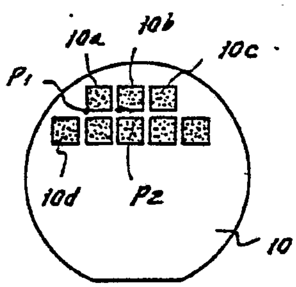


Fig. 5

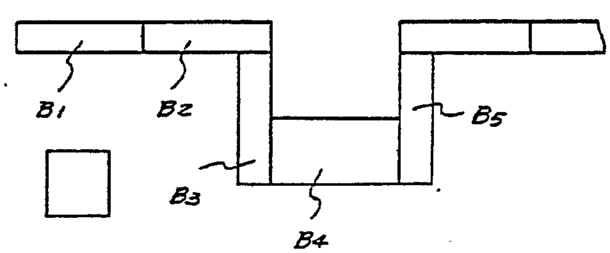

Fig. 6A

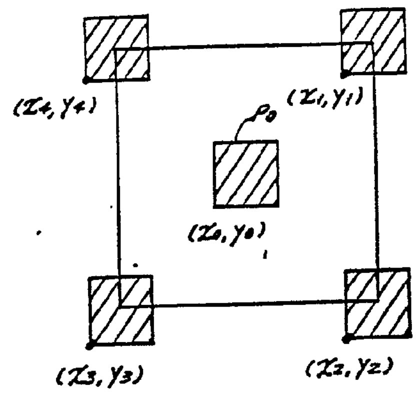


Fig. 6B

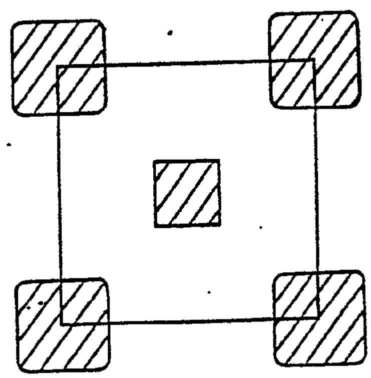

Fig. 6C

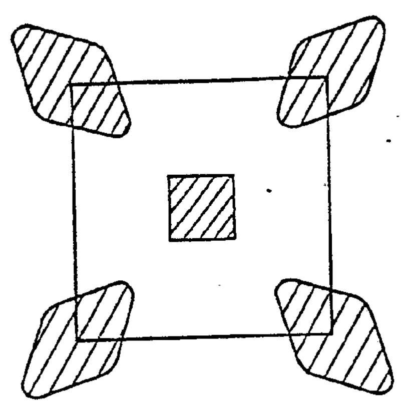

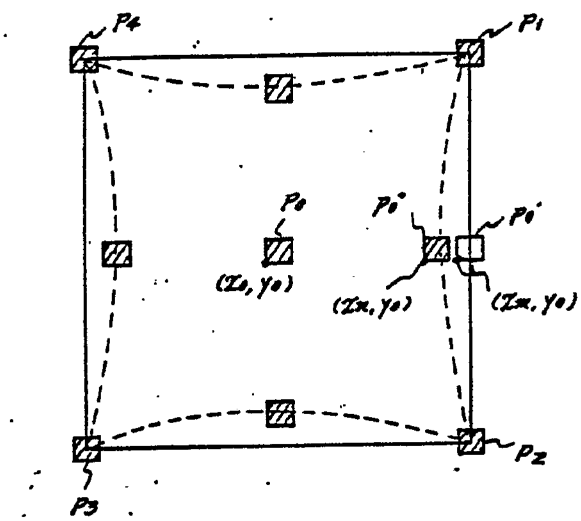


Fig. 6D

Fig. 7

16

| ADRESS | | FIELD CURVATURE | ASTIGMATISM | | DISTORTION | |
|---|---|---|---|---|---|---|
| X | Y | | X | Y | X | Y |
| $a_{x1}$ | $a_{y1}$ | $f_1$ | $S_{x1}$ | $S_{y1}$ | $d_{x1}$ | $d_{y1}$ |
| $a_{x1}$ | $a_{y2}$ | $f_2$ | $S_{x2}$ | $S_{y2}$ | $d_{x2}$ | $d_{y2}$ |
| $a_{x1}$ | $a_{y3}$ | $f_3$ | $S_{x3}$ | $S_{y3}$ | $d_{x3}$ | $d_{y3}$ |
| ⋮ | ⋮ | ⋮ | ⋮ | ⋮ | ⋮ | ⋮ |
| $a_{x1}$ | $a_{yi}$ | $f_i$ | $S_{xi}$ | $S_{yi}$ | $d_{xi}$ | $d_{yi}$ |
| $a_{x2}$ | $a_{y1}$ | $f_{i+1}$ | $S_{xi+1}$ | $S_{yi+1}$ | $d_{xi+1}$ | $d_{yi+1}$ |
| ⋮ | ⋮ | ⋮ | ⋮ | ⋮ | ⋮ | ⋮ |
| $a_{xj}$ | $a_{yi}$ | $f_j$ | $S_{xj}$ | $S_{yj}$ | $d_{xj}$ | $d_{yj}$ |

Fig. 8

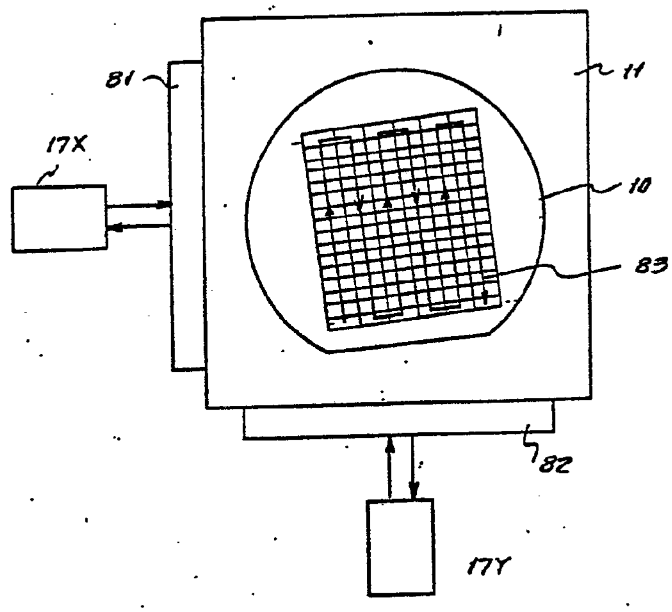
81
11
17X
10
83
82
17Y

Fig. 9

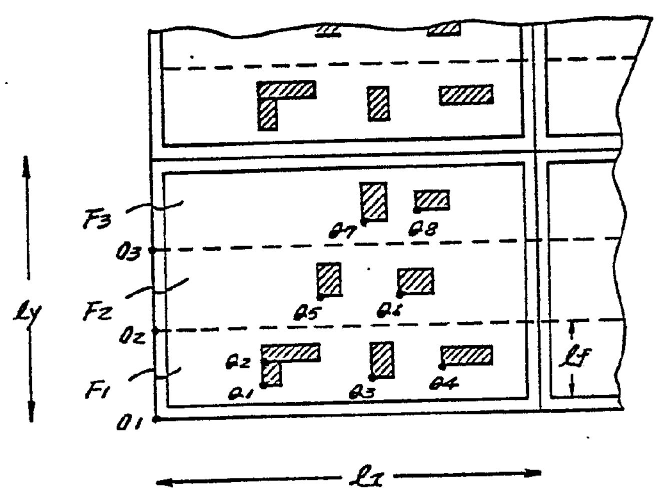
F3
03
Fz
0z
F1
01
ly
Q7
Q8
Q5
Q6
Q2
Q1
Q3
Q4
lf
lx

Fig. 10

13

| FIELD NUMBER | POSITION X | POSITION Y | SIZE X | SIZE Y |
|---|---|---|---|---|
| 0 1 (F1) | $x_1$ | $y_1$ | $l_1$ | $l_1'$ |
| 0 1 (F1) | $x_2$ | $y_2$ | $l_2$ | $l_2'$ |
| 0 1 (F1) | $x_3$ | $y_3$ | $l_3$ | $l_3'$ |
| 0 1 (F1) | $x_4$ | $y_4$ | $l_4$ | $l_4'$ |
| 1 0 (F2) | $x_5$ | $y_5$ | $l_5$ | $l_5'$ |
| 1 0 (F2) | $x_6$ | $y_6$ | $l_6$ | $l_6'$ |
| 1 1 (F3) | $x_7$ | $y_7$ | $l_7$ | $l_7'$ |
| 1 1 (F3) | $x_8$ | $y_8$ | $l_8$ | $l_8'$ |

Fig. 11A

14

| FIELD NUMBER | POSITION OF 01 | |
|---|---|---|
| 0 1 | $0_{1x}$ | $0_{1y}$ |

Fig. 11B

14

| FIELD NUMBER | POSITION OF 02 | |
|---|---|---|
| 1 0 | $0_{2x}$ | $0_{2y}$ |

Fig. 11C

14

| FIELD NUMBER | POSITION OF 03 | |
|---|---|---|
| 1 1 | $0_{3x}$ | $0_{3y}$ |